Europäisches Patentamt

European Patent Office

Office européen des brevets

(11) Publication number: **0 174 397**
**A2**

# EUROPEAN PATENT APPLICATION

(21) Application number: **84305276.2**

(22) Date of filing: **03.08.84**

(51) Int. Cl.⁴: **G 06 F 7/52**
**H 03 K 19/177**

(30) Priority: **05.08.83 US 520880**
**03.10.83 US 538634**

(43) Date of publication of application:
**19.03.86 Bulletin 86/12**

(84) Designated Contracting States:
**DE FR GB**

(71) Applicant: **TEXAS INSTRUMENTS INCORPORATED**
**13500 North Central Expressway**
**Dallas Texas 75265(US)**

(72) Inventor: **Tubbs, Graham S.**
**P.O. Box 26811**
**Tempe, AZ 85282(US)**

(74) Representative: **Abbott, David John et al,**
**Abel & Imray Northumberland House 303-306 High**
**Holborn**
**London, WC1V 7LH(GB)**

(54) Dummy load controlled multi-level logic single clock logic circuit.

(57) A multi-level logic circuit includes a first plurality of logic circuits that are connected in a cascade arrangement. A second plurality of dummy logic circuits also connected in casacade arrangement are used to generate logic pulses for evaluating the first plurality of logic circuits. A clock source provides a precharged signal to the first plurality of logic circuits and the second plurality of dummy logic circuits and an evaluation circuit is used to combine the clock signal with an output signal from the dummy logic signal to obtain an evaluation signal for evaluating the logic states of the first plurality of logic circuits.

A digital multiplication circuit for a microprocessor utilizes a modified Booth algorithm for implementing the digital multiplication of two numbers and includes a Booth recoder for recoding the multiplier into a selected number, n, of Booth operation sets where n is a positive integer that equals one-half the number of bits in the multiplier. Each operation set is applied to a second plurality of n partial products selectors which are connected in cascade arrangement according to multiplicand sets and wherein each partial product selector multiplicand set implements one of the recoded Booth operation sets. The outputs of the partial product selectors are summed by a summation means and a domino circuit means provides an evaluation pulse for each member of the partial product selector at the completion of the Booth operation set that is connected to the partial product selector.

./...

EP 0 174 397 A2

Fig.1

-1-

# DUMMY LOAD CONTROLLED MULTI-LEVEL
# LOGIC SINGLE CLOCK LOGIC CIRCUIT

## BACKGROUND OF INVENTION

This invention relates to multi-level logic circuits and in particular, those multi-logic level circuits that operate with a single clock pulse.

Dynamic multi-level logic circuits that are manufactured by the metal oxide silicon process require a multi phase clock to insure the proper implementation of the desired logic function. The implementing of a priority multi-level logic fucntion requires the partitioning of the logic into time slots and then assigning the required number of clock phases to cover the worst case or maximum number of logic levels that are to be implemented. The phases of the clock are generated by dividing a clock signal from a basic signal source down. This results in multiple phases of clock signals, typically all phases being related to a basic source frequency that is divided down by one, two, four, etc., which means that all the phases of the clock are multiples of the basic source frequency. In this scheme, the frequency of operation is increased until one phase, which is normally only one, becomes critical. When this happens, many of the logic levels are left with redundant time available to complete the decision operation.

Although MOS circuits are considered economical to manufacture, because of the necessity of requiring separate clock phases for precharging and evaluation of the logic levels, these circuits are normally not utilized in many current dynamic logic applications because of the inherent slowness of the circuits when compared to other types of logic circuits.

BACKGROUND OF THE INVENTION:

This invention also relates to digital multiplication circuits, and more particular to digital multiplication circuits for use with a microprocessor in which the digital multiplication circuit is controlled by a domino control circuit.

A major limitation in the use of field effect transistor circuits and in particular, of large scale integration circuits, is the restriction associated with extending dynamic logic circuits, such as those found in a multiplier, to high-speed applications due to the necessity of multiple clocks that are required for the implementation of logic circuits with field effect transistors. Traditionally, there have been multiple clock phases required for the implementation of field effect transistor logic circuits. A precharge phase is necessary to precharge all of the data lines that interconnect the transistors used to configure the logic circuits and a second clock phsae is required to evaluate the results of the implementation of the logic functions. In the cases where the logic circuits are connected together and each stage is dependent on the results of a preceding logic stage, there is a requirement for multi-phase clock functions. A first clock phase precharges all of the data lines for all of the logic circuits; a second clock phase evaluates the first logic level after which the results are applied to a second logic level which is evaluated by a third clock phase and so on through the total number of logic levels. Thus, for an N logic level function to be implemented by field effect transistor circuits, there is a requirement for N+1 clock phases, a phase to precharge all of the data lines, and a phase for each logic level to be evaluated by. The time slot ordering of the logic levels thus results in many of the logic circuits idily waiting for their turn to be evaluated with the overall consequence being that these circuits are exceptionally slow. Thus has traditionally not been a problem in the cases where the field effect transistor logic circuits are used for a hand-held calculator or other such applications. However, as more complicated requirements for the circuits develop, the need for speed in implementing complex logic functions becomes critical. The luxury of having circuits waiting for the appropriate time slots to be evaluated is not possible in applications that require high speed, nanosecond range.

The minimization of time in a microprocessor system that is required to implement multiplication functions may be reduced from many processing cycles of the microprocessor to a relative few number of microprocessor cycles through the implementation of a hardware multiplier that implements the modified Booth algorithm of digital multiplication. However, even this reduction in time is not sufficient to provide a field effect transistor type microprocessor witrh the speed necessary for modern technical applications.

## SUMMARY OF THE INVENTION

A multi-level logic circuit includes a first plurality of logic circuits that are connected in a cascade arrangement. A second plurality of dummy logic circuits also connected in cascade arrangement is used to generate logic pulses for evaluating the first plurality of logic circuits. A clock source provides a precharge signal to the first plurality of logic circuits and the second plurality of dummy logic circuits and an evaluation circuit is used to combine the clock signal with an output signal from the dummy logic signal to obtain an evaluation signal for evaluating the logic states of the first plurality of logic circuits.

A multi-level logic circuit is disclosed in which the evaluation pulse is provided to correspond with the availability of data to be evaluated at each level.

The evaluation circuit is combined with a multi-level logic circuit to obtain a high speed programmable logic array.

SUMMARY OF THE INVENTION:

A digital multiplication circuit for a microprocessor
utilizes a modified Booth algorithm for implementing the
digital multiplication of two numbers and includes a Booth
recoder for recoding the multiplier into a selected number, n,
of Booth operation sets where n is a positive integer that
equals one-half the number of bits in the multiplier. Each
operation set is applied to a second plurality of n partial
products selectors which are connected in cascade arrangement
according to multiplication set and wherein each partial
product selector multiplication set implements one of the
recoded Booth operation sets. The output of the partial
product selectors are summed by a summation means and a domino
circuit means provides an evaluation pulse for each member of
the partial product selector at the completion of the Booth
operation set that is connected to the partial product
selector.

In multi-level logic circuits such as a multiplier,
performance is enhanced in the speed of operation by detecting
when each level of the multi-level logic circuit is ready for
evaluation through the use of a domino control circuit.

The domino control circuit implements a worst case time
delay for the propagation of a single clock pulse and its
compliment to generate exactly when a corresponding stage of
the Booth multiplier is in a position to be evaluated.

A summation means includes a plurality of summation
circuits that are connected between selected members of hte
plurality of partial product selectors. To ensure the earliest
possible evaluation of data within the summation set, the domino control circuit also includes a summation circuit which represents the worst possible case as far as time delays go for the summation circuit to perform its logical operation and have data ready to be evaluated. At the expiration of that time, the domino control circuit provides an evaluation enable pulse to the next level of logic within the multiplier.

These embodiments, as well as advantages and objective of the invention, may be obtained from reading of the specifications with the figures.

-7-

## BRIEF DESCRIPTION OF THE DRAWINGS

FIGURE 1 is a block diagram of a microprocessor incorporating a multiplier according to the invention;

FIGURE 2 is a block diagram of a domino control logic circuit;

FIGURE 3 is a block diagram of the multiplier of Figure 1 according to the invention;

FIGURE 4 is a timing diagram of the multiplier of Figure 3;

FIGURES 5A and 5B are simplified schematic diagrams of the multiplier of Figure 3;

FIGURE 6 is a schematic diagram of each of the Booth decoder stages of Figure 5B;

FIGURE 7 is a schematic diagram of the partial product selectors 191 of Figures 5A and 5B;

FIGURE 8 is a schematic diagram of the PPR delay circuit of Figure 5A;

FIGURE 9 is a schematic diagram of a carry-save-adder circuit used in Figures 5;

FIGURE 10 is a schematic diagram of a carry-ripple-adder used in Figures 5;

FIGURE 11 is a carry circuit used in the embodiment of Figures 5;

FIGURES 12A and 12B are the intermediate registers in the output stages of Figure 5;

FIGURE 13 is the store control circuit of Figures 5;

FIGURE 14 is the buffer control of Figures 5;

FIGURE 15 is a schematic diagram of the intermediate registers 21 of the Figures 5; and

FIGURE 16 is a schematic diagram of a programmable logic array embodying the invention.

DETAILED DESCRIPTION OF THE PREFERRED EMBODIMENT:

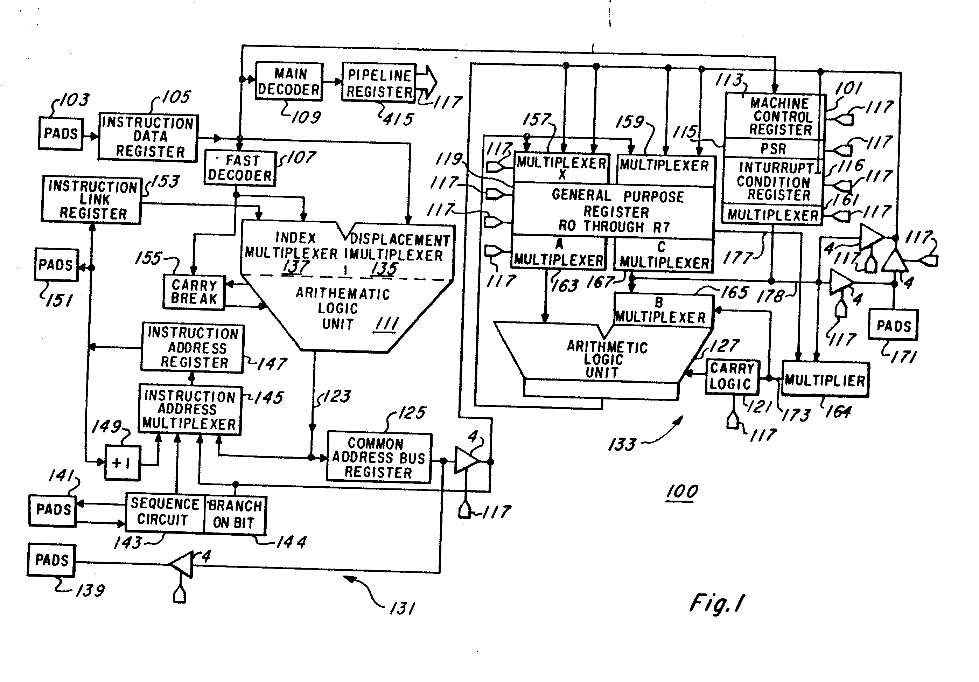

In Figure 1, there is illustrated a microprocessor which incorporates a multiplier 161 according to the invention. Instructions from an I/O terminal (not shown) are provided via the pads 103 to an instruction data register 105 and are then applied to a fast decoder 107, a main decoder 109, and an address arithmetic unit 111. The main decoder 109 decodes the instructions into control signals which are used throughout the microprocessor. These control signals are stored in the control pipeline register 115 which conveys the decoded signals via data bundle 117 to the appropriate circuitry including the multiplier 161.

The microprocessor 100 has essentially two portions, an instruction portion represented in the area of 131 and a data portion represented in the area of 133. The address arithmetic unit 11 receives data from the instruction data register 105 via a displacement multiplexer 135 as well as data from the instruction link register 153 or the general purpose register 119 via the index multiplexer 137, based on the results of the fast decoder 107.

After the appropriate arithmetic operation is performed as directed by the carry break logic 155, the output of the address arithmetic unit 123 is latched in the common address bus register 125. The output of this register may subsequently be applied to the I/O of the integrated circuit via pads 139 to address either the data memory or input/output address space or to an internal bus for use as a constant. The output of the address arithmetic unit is also applied to the instruction address multiplexer 145. The output of this multiplexer is latched in the instruction address register 147. Another input to the multiplexer, an incremented version of the instruction address register, is provided by 149. The control of the multiplexer 145 is provided by the sequencing circuit 143. The sequencing circuit 149 controls branches and interrupts which may be received via the pads 141. The output of the instruction address register 147 is applied to the I/O via pads 151 for addressing an instruction in memory. The instruction address register 147 is also latched in the instruction link register 153 after a one-cycle delay.

The arithmetic logic unit 127 receives data from a general purpose register 119 via the A multiplexer 163 and data from a general purpose register 119, machine control register 113, program status register, or interrupt condition register via the C multiplexer or the multiplier 161 via the B multiplexer. The carry into the arithmetic logic unit is from the carry logic 121 under the control of the main decoder. The output of the arithmetic logic unit may be adjusted in the case of an overflow--by the saturation logic 129. The output is then fed back to the general purpose registers 119 via the X and Y multiplexers 157 and 159.

When an instruction calling for a multiplication is decoded by the main decoder 107, general purpose register five and the result of the C multiplexer are multiplied by the multiplier 161 and the result latched in registers internal to that block.

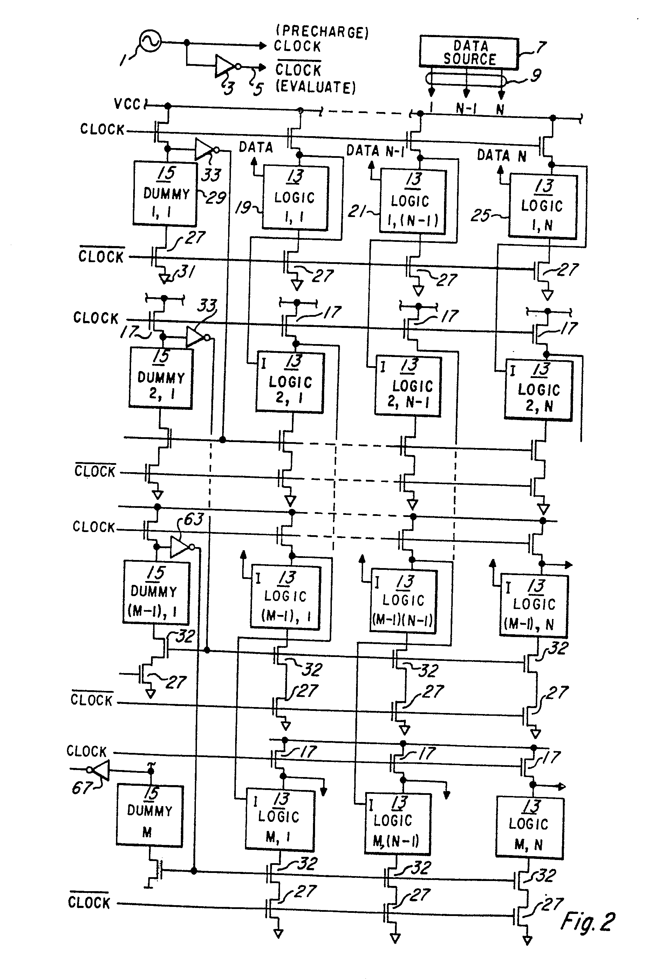

Figure 2, to which reference should now be made, provides the basic theory of the operation of the multiplier 161 through the use of a domino control logic circuit that is incorporated therein. There is shown a block diagram of a domino control multi-level logic as well as to an inverter 3, where an inverted clock signal clock is applied to the domino circuit multi-level logic system 10. A clock source 1 provides a clock signal to the dummy load control multi-level logic system via conductor 5. A data source 7 provides parallel data signals, DATA 1 through DATA N, via data bus 9 to the domino control multi-level logic system 10. The domino control multi-level logic system includes a M times N logic elements 13. The logic elements are divided into words having a width of N logic elements that are connected together in cascade arrangement by data words to form a N by M matrix, which corresponds to a multi-level logic system of M level, having a width od N bits. Additionally, there are M domino circuits 15 that are also connected in cascade arrangement. Each logic element 13 and each domino circuitry 15 is precharged by the clock signal activating the gate of transistors 17, causing VCC, a voltage provided from a source not shown, to be applied to the corresponding logic element 13 and domino circuits 15. A 1, 1 logic element 19, 1, (N-1) logic element 21 and 1, N logic element 25, are evaluated by the clock signal activating transistors 27 which connect the corresponding logic elements to reference potential or Vdd as indicated by arrows 31. A 1, 1 domino circuit 29 is also evaluated by the clock signal and because the 1, 1 domino circuit 29 is connected to represent the worst case condition for any of the logic elements 13 that are connected in the first row an evaluation pulse is provided by an inverting amplifier 33 to the logic elements 13 that are located in the second row of the domino control multi-level logic system at a time to ensure proper evaluation. The logic elements in th second row, of course, are connected in cascade arrangements with the logic elements in the first row and are thus able to be evaluated as soon as an evaluation pulse is provided to the gates of the transistors 37, which are connected with transistor 17 to form an AND gate for ANDing the output of the inverter 33 with the clock signal provided from the inverter 3. It should be noted that data from the data source 9 is connected to the corresponding input terminal of the logic elements in the first row that is present and the Q terminals are connected to a corresponding logic element on the second row at the input terminals, thus, creating the cascade connection. This configuration is carried on completely through all M rows. The domino circuit 15 of each row is similarly connected in cascade arrangement, with each representing the worst possible condition as far as propogation delays of the signal there through to insure that when an evaluation pulse is provided on the output of the inverters 33 that the corresponding logic has completed all logical operation. The evaluation of the domino control multi-level logic system 10 only requires (M-1) domino circuit systems; however, if the data that is provided on the output of the logic elements 13 are members of the M row and is to be stored in a memory location, then a store pause may be provided on the final output inverter 33 of the M domino circuit 39. Thus the generation of the evaluation pulse for each row of logic elements is comparable to a line of end standing dominos falling with the fall of each domino producing the evaluation pulse. This provides an asynchronous operation for evaluating field effect transistor logic circuits.

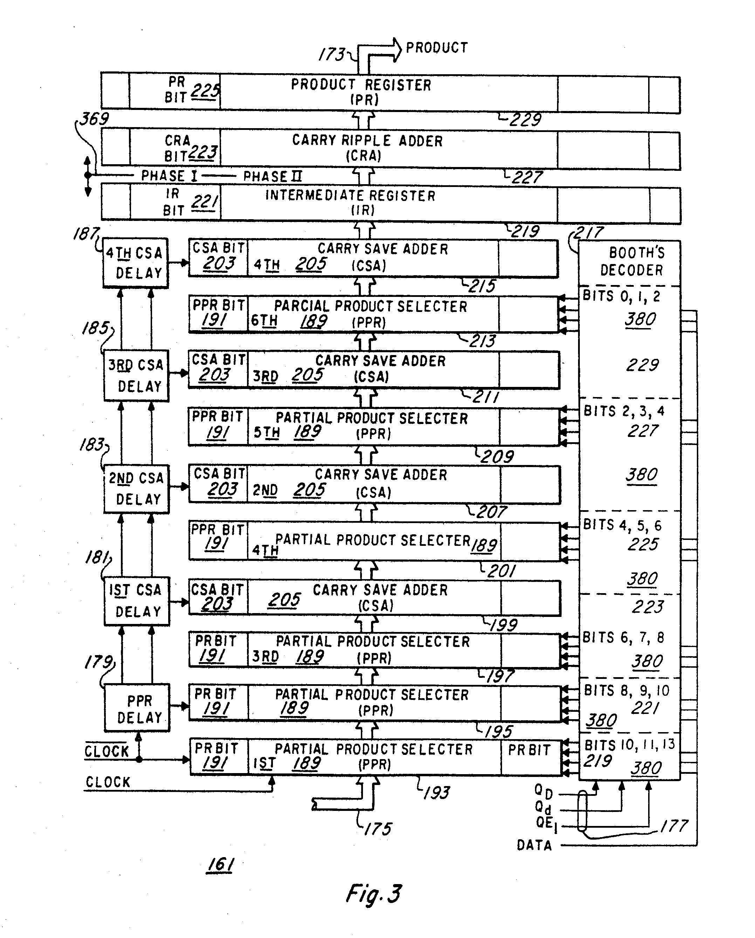

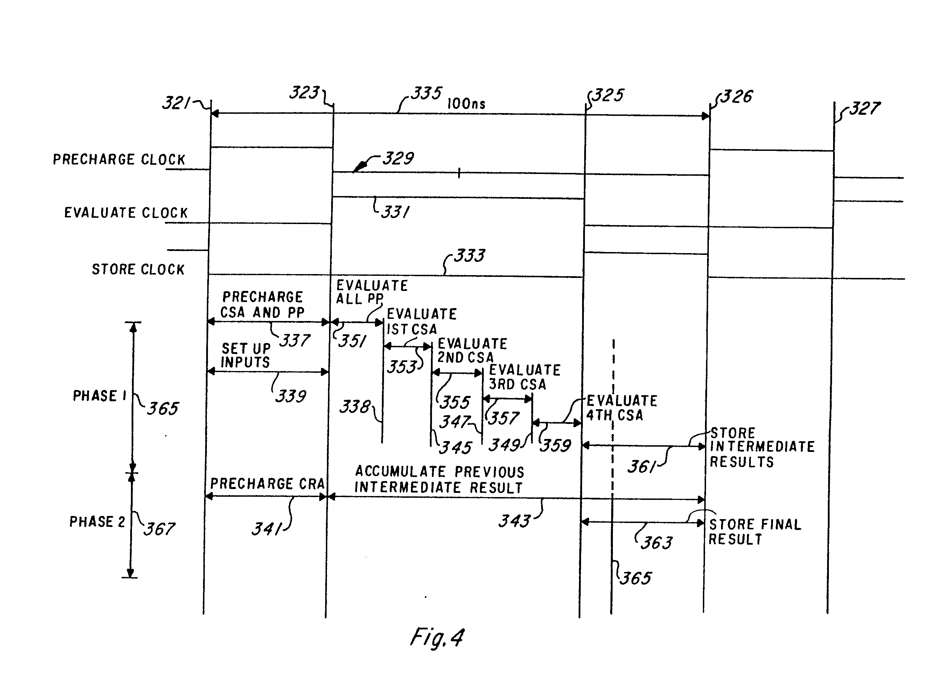

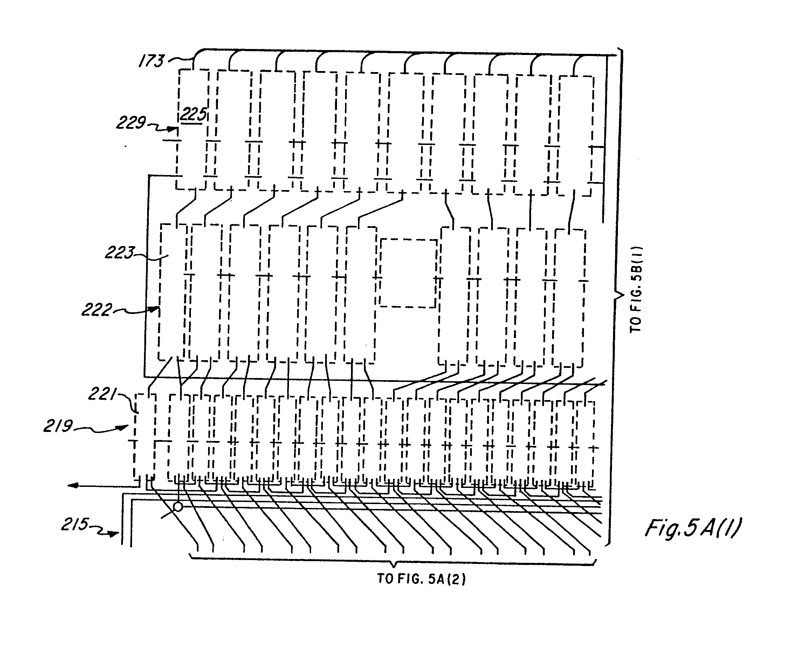

Figure 3, to which reference should now be made, is a block diagram of the multiplier 161 of Figure 1 incorporating the domino principle discussed in conjunction with Figure 2. The multiplicand is applied to the six partial product selectors, rows 193, 195, 197, 201, 209, and 213, via data bus 175 from the C multiplexer 167 of Figure 1. The multiplier is applied to Booth recoder 217 from general purpose register 5, 159, via conductor bundles 177. In the embodiment of Figure 3, the multiplier is 13 bits and the multiplicand is 16 bits. However, the examples presented here are applicable to any size multiplier and any size multiplicand. All of the circuits described in Figure 3 are precharged by a first phase, clock QP, as shown in Figure 2 and are evaluated during selected times, as will be discussed in conjunction with Figure 4 with an evaluation pulse. All of the partial product selectors are evaluated simultaneously by clock QE. The first partial product selector 193 is controlled by Booth recoder 219 which uses multiplier bits 10, 11, and 12. The second partial product selector 195 is controlled by a Booth recoder 221 which uses multiplier bits 8, 9, and 10. The third partial product selector 197 is controlled by a Booth recoder 223 which uses multiplier bits 6, 7 and 8. The fourth partial product selector 201 is controlled by Booth recoder 225 which uses multiplier bits 4, 5, and 6. The fifth partial product selector 209 is controlled by Booth recoder 227 which uses multiplier bits 2, 3, and 4. The sixth partial product selector is controlled by a Booth recoder 229 which uses multiplier bits 0, 1, and 2, the most significant bits. The partial products from first three selectors, 193, 195, and 197 are summed by carry-save-adder 199. The carry-save adder is evaluated by an evaluation pulse that is provided by partial product selector delay 179. The outputs of the CSA 199 and the partial product from selector 201 are summed by CSA 207. The evaluation pulse for CSA 207 is provided by CSA delay 181. The outputs of the CSA 207 and the partial product from selector 209 are summed by CSA 211. The evaluation pulse for CSA 211 is provided by CSA delay 183. The outputs of the CSA 211 and the partial product from selector 213 are summed by CSA 215. The evaluation pulse for CSA 215 is provided by CSA delay 185. The output of CSA 215 are in intermediate register 219. This completes the activity of one clock cycle. On the subsequent clock cycle the contents of the intermediate register 119 are summed by the carry-ripple adder 227. This produces the product which is latched in the product register 229. The product register may then be

-14-

applied to the arithmetic logic unit 127 via the B-multiplexer 165.

In Figure 4, to which reference should now be made, there is shown a timing diagram of Figure 3, which should be used in conjunction with Figure 4. In Figure 3, the data enters via conductor 175 at the bottom of the page, and flows through the partial product selector and the carry-save adders and eventually emerges from the product selector 229 at the top of Figure 3. The separation between the intermediate register 219 and the carry-ripple adder 227 indicates the completion of a first phase 365 and the initiation of a second phase 367. This separation is indicated by line and arrow combination 369. In Figure 4, vertical lines 321 and 326 represent the initiation of a multiply cycle in which a precharge clock will precharge the circuits within the multiplier 161 including the carry-save adders and selectors as indicated by arrow 337; provide the input data on conductor bus 175 as indicated by dimension line 339; as well as precharge the carry-ripple adder 227 as indicated by dimension line 341. At vertical line 323, the precharge clock is removed as indicated by waveform 329 and the evaluate clock is provided as indicated by waveform 331. All partial product selectors are evaluated in the period of time between vertical lines 323 and 338 as indicated by dimension line 351. The carry-save adders are sequentially evaluated with the first carry-save adder 199 being evaluated in the period of time between vertical line 338 and vertical line 345. The evaluation pulse for the carry-save adder 199 is provided by the PPS delay 179. The first CSA delay 181 provides a second evaluation pulse to the second carry-save adder 207 during the period of time between vertical line 345 and vertical line 347. The CSA evaluation pulse is indicated by dimension line 355. A third CSA evaluation pulse is provided to the third carry-save adder 211 during the period of time that is indicated by dimension line 357 which is the distance between vertical lines 347 and 349. The fourth carry-save adder 215 is evaluated by a pulse that is provided by the third CSA delay 185. This pulse occurs between the vertical lines 349 and the vertical line 365 of Figure 4 and is represented by dimension line 359. The results of evaluation are stored in the intermediate register 219 during the period of time between vertical line 325 and the vertical line 325 thereby completing the multiplication and on the next cycle the data contained within the intermediate register 219 is summed by the carry-ripple adder 227 and applied to the product register 229 for application to the arithmetic logic unit 127 of Figure 1. Figure 4 illustrates that Phase I represents the operations that are performed below the line 369 of Figure 3, and Phase II occurs after the line 369 with each phase being initiated by a clock phase, Phase I and Phase II. Therefore, the multiplier disclosed and discussed above is able to implement a complicated multiplication function and provide the information to an arithmetic logic unit at the rate of one per clock cycle.

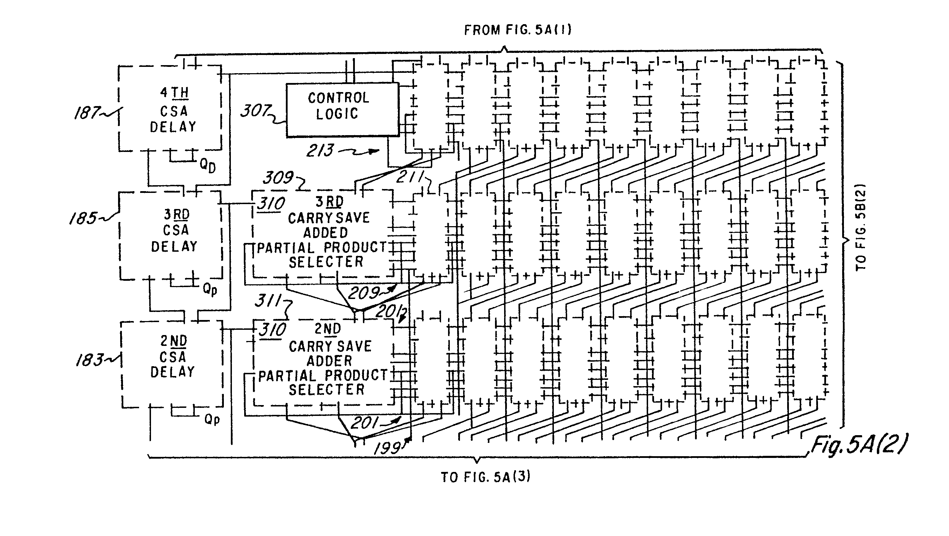

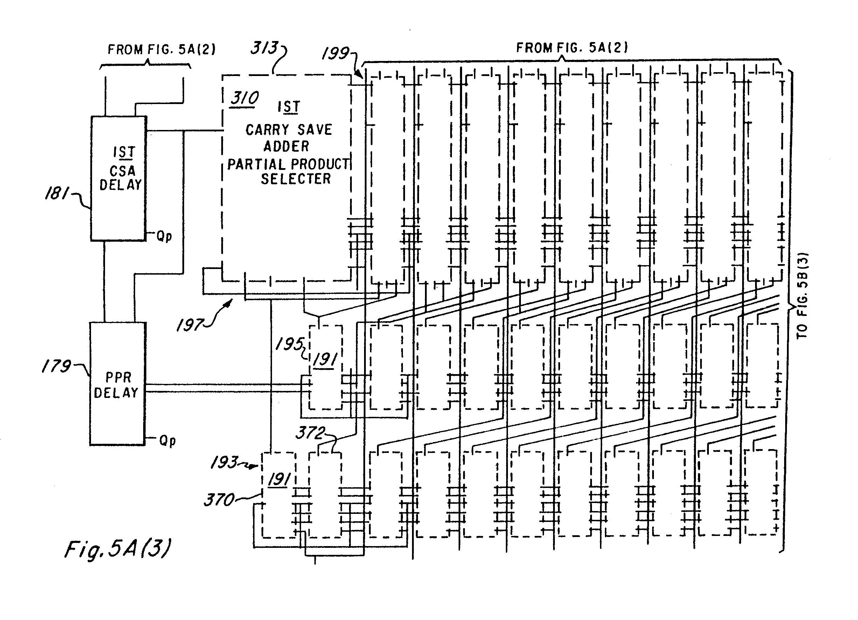

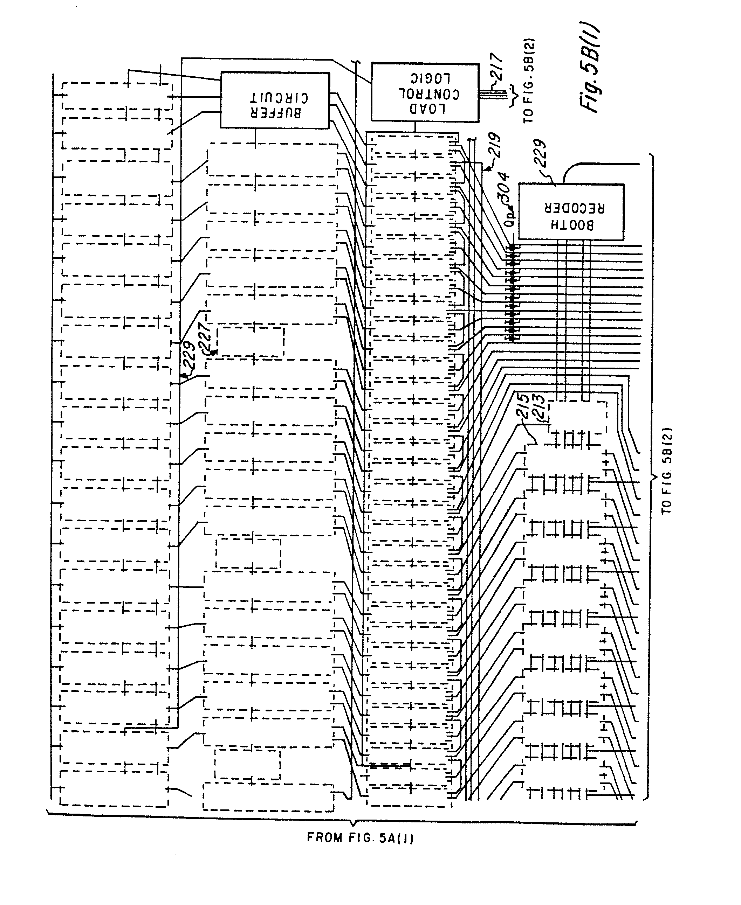

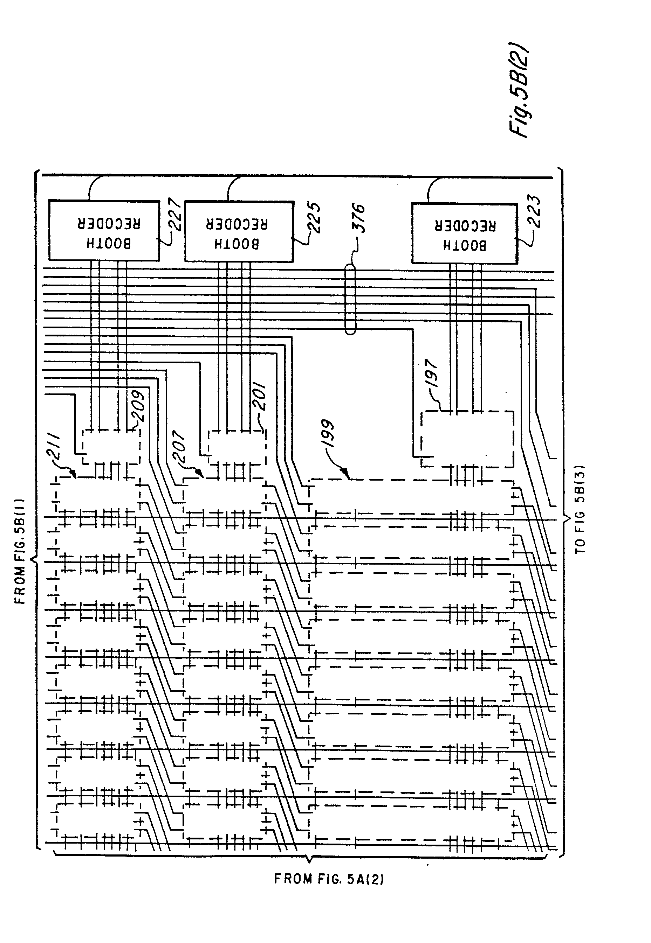

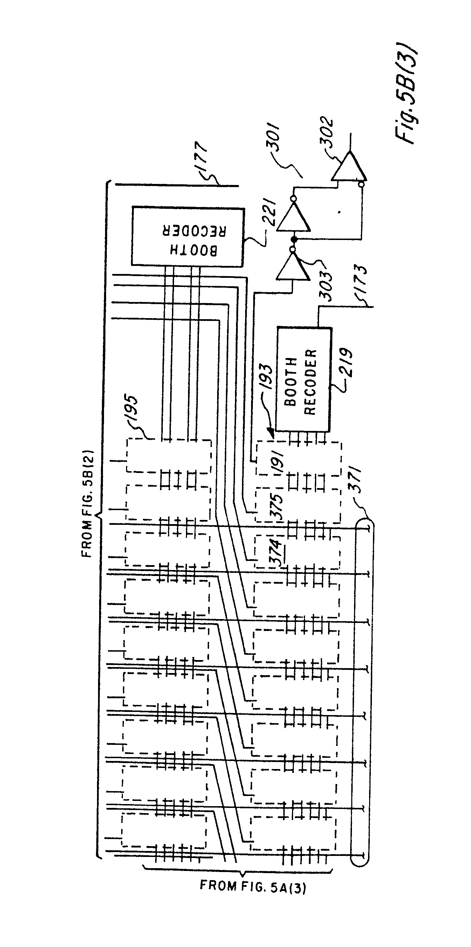

Figures 5A and 5B are simplified schematic diagrams of a 16 bit by 12 bit multiplier according to the invention. The first partial product selector row 193 includes 19 cells 191 and receives the most significant bit in registers 370 and 372 with the least significant bit being applied to cell 374 in Figure 5B. The multiple cells for the most significant bit are necessary because the most significant bit is a sign bit, and is applied to more than two separate loads. Two extra cells are required to implement the Booth operation.

The decoded Booth operand will cause the partial product selectors to perform the functions of the Booth operand. These functions are listed in Table One. In the present application of the preferred embodiment of Figure 5

-16-

provisions are made to double the number by shifting each bit to the left. Table Two provides the number of cells for each row and Table One provides the Truth Table for the decoding Booth algorithm.

TABLE ONE

3 bit number

| 000 | Add 0 to value in previous row of register |
| 001 | Add multiplicand to value in previous row of registers |
| 010 | Add multiplicand to value in previous row of registers |
| 011 | Add two times multiplicand to value in previous row |
| 100 | Subtract two times multiplicand from previous value |
| 101 | Subtract multiplicand from previous value |
| 110 | Subtract multiplicand from previous value |
| 111 | Subtract 0 from previous value |

-17-

## TABLE TWO

| Row, Cell and Reference Number | | Number of Cells |
|---|---|---|
| 1 | Partial product selector 193, | 19 |
| 2 | Partial product selector 195, | 19 |
| 3 | Partial product selector 197, | 19 |
| 4 | Carry save adder 199, | 18 |
| 5 | Partial product selector 201, | 19 |
| 6 | Carry save adder 211, | 18 |
| 7 | Partial product selector 213, | 19 |
| 8 | Carry save adder 215, | 18 |
| 9 | Intermediate register 219, | 54 |
| 10 | Carry ripple adder 227, | 26 |
| 11 | Product register 229, | 28 |

To minimize time delay, a design limitation of no more than two loads per signal source was implemented in the preferred embodiment, thus insuring that the worst case condition is a single load. This limitation is taken into consideration during the generation of the evaluation pulses. The extra cells 371 and 375 are provided and used in the implementation of the Booth alogrithm that is provided by the first Booth recoder 219. The outputs of the cells are shifted two bits tro the right and applied to the second partial product selecter 195. The results of the shift are applied to the IR (Intermediate) register 219 via the conductor bundle 376 for accumulation therein. The second partial product selector's output is applied to the third partial product selectors 197, row 199 the output of which is applied to a carry-save adder. Each carry-save adder 310 used to create the rows of carry-save adders is a full adder and thus, requires 3 inputs; that is why the output of each of the first, second and third partial product selectors is applied to the first carry-save adder row 199 to provide three inputs to be summed. Thereafter, the output of each full adder 310 is applied to a following full adder 310 where its output is combined with the output of a following partial product selector and totaled with the preceding carry-save adder 310 that also includes the carry output until the total results of the multiplication function as implemented by the Booth algorithm is provided to the intermediate register 219 in accordance with the function that has been discussed in conjunction with Figures 3 and 4.

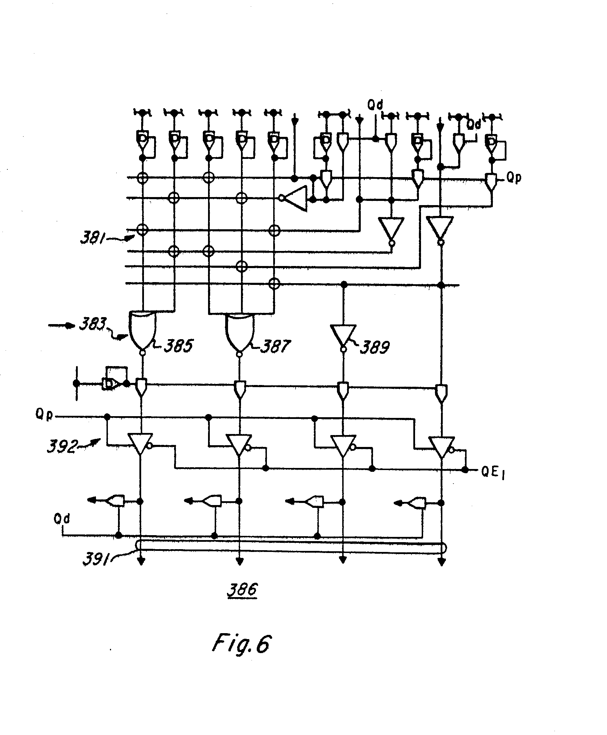

Figure 6 is a schematic diagram of each Booth recoder stage 380 and includes essentially a programmable logic array 381 where the Booth algorithm is decoded by the programmable logic array 381 and applied to logic devices 383 that include NOR gates 385, 387 and inverter 389. The output of the logic devices 383 is applied to the partial product selectors via the data bus 391 under the control of an evaluation pulse QE1, which is represented by dimension lines 351 of Figure 4 and provided by the gated buffer amplifiers 392.

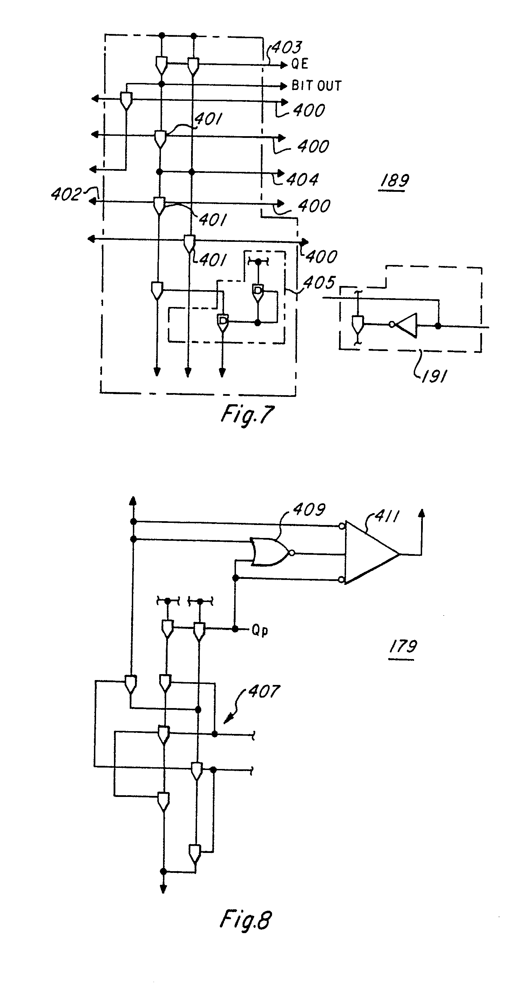

Figure 7 is a schematic diagram of each partial product selector 191 in which the inputs to the partial product selector are provided via data bus 400 from the Booth recoder. The output from each partial product selector is provided via data bus 403. The input to each selector cell 189 is provided via data bus 175 and inverted by 191. However, there is no input such as the least-significant bit position, then the circuit 187 has a bias provided by a circuit 405. The bias is generated by two depletion transistors being connected as illustrated in Figure 7 to a voltage source not shown. The shift of the partial product is accomplished via paths 402 and 404.

-19-

The PPR delay circuit 179 is illustrated in Figure 8 and is used to delay the evaluation pulse that is applied to the carry-save adder circuit 199 by a propogation delay that represents the worst case conditions of the partial product selectors. It includes a plurality of transistors 407 whose outputs are connected and combined by an NOR gate 409 and an amplifier 411, the results of which are applied to the first CSA delay circuit 181 and the first CSA row 199. Throughout the discussion of the figures, QE represents the evaluation pulse QP represents the precharge pulse.

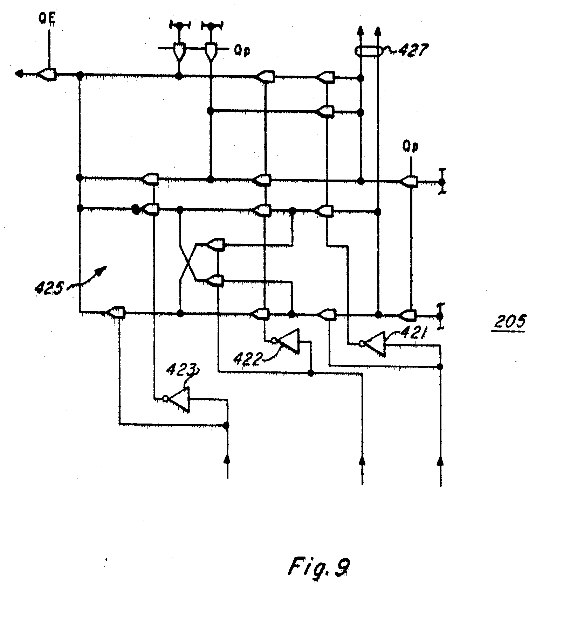

Figure 9 is a schematic diagram of a carry-save adder circuit 205 as well as CSA delay 183, being that the circuits are identical. There are three inputs supplied to the inverters 421, 422, and 423 for the summation of th circuit by the adder circuit that is provided through the implementation of the transistor logic 425, the output of which is provided on data bus 427. This is a full adder circuit and provides the sum output as well as a crry output via data bus 427.

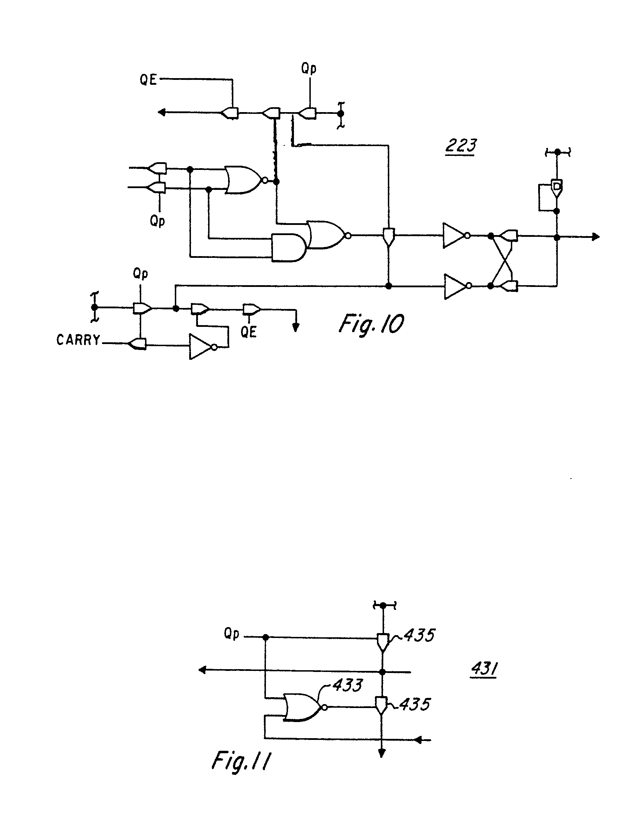

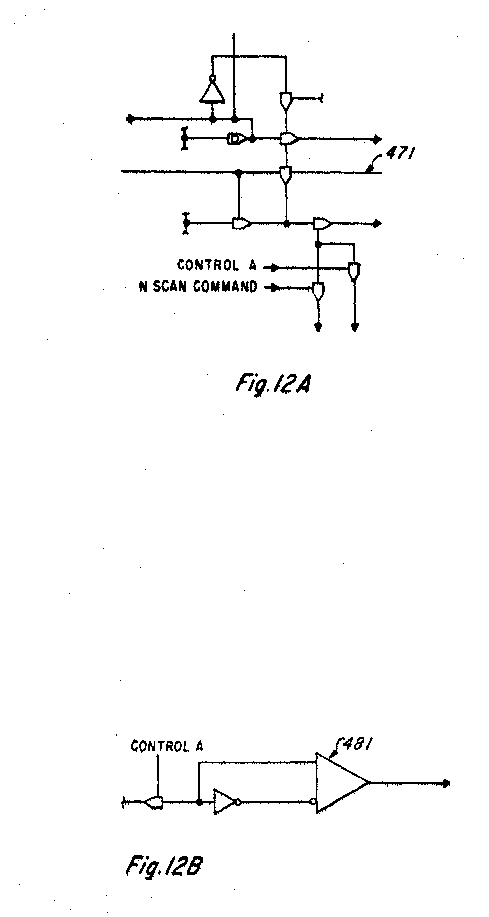

Figure 10, which is similar to the circuit of Figure 9, is the carry-ripple adder and represents each stage of the device 223 in which the intermediate register 219 outputs are summed by the carry ripple adder 223. As shown in the Figures 5 separating each group of 5 carry-ripple adders is a carry circuit 431 which is illustrated in Figure 11 and includes an NOR gate 433 and two MOS transistors 435. Figure 10B is the circuit which provides the carry input for the carry-ripple adder.

Figure 12A and 12B are the intermediate registers in the output buffer stages and also demonstrate the fact that the microprocessor controls the loading and storage of data within the transistors located at 471.

-20-

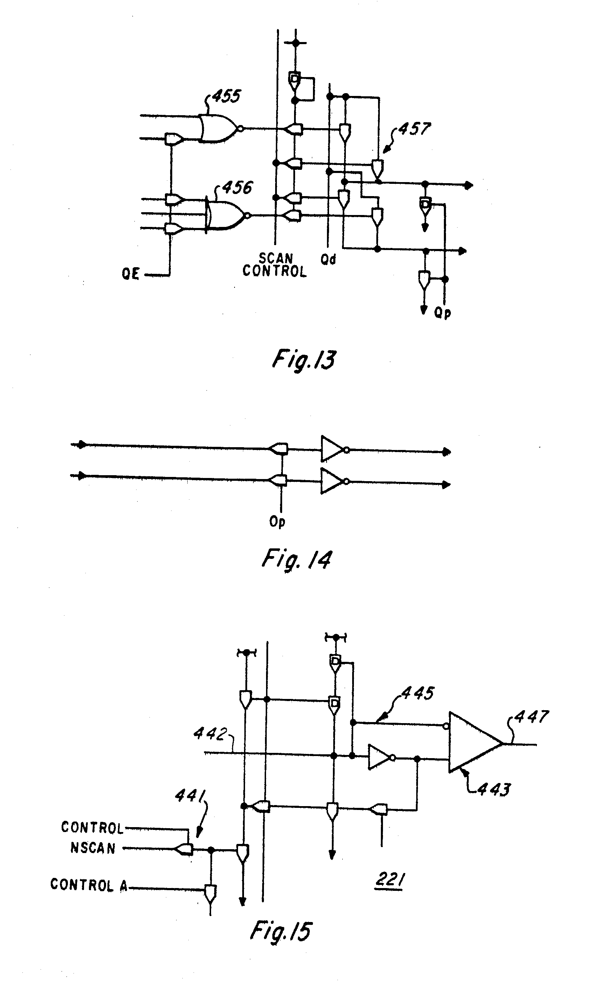

Figure 13 is a store control circuit of Figures 5 and includes the NOR gate 455, 456 and the transistors 457.

Figure 14 provides a schematic diagram of the circuit which is used to delay the output of the two least-significant intermediate register bits (which do not need to be accumulated) into the product register.

Figure 15 is the block schematic diagram of the product register 229. The store control circuit is illustrated in Figure 13 in which here again it is used in conjunction with the scan control that is provided by the computer as well as the precharge pulse and the evaluation pulse and includes gated OR functions that are implemented by OR gates 444, 445 and 446, and the transistor circuits generally at 457.

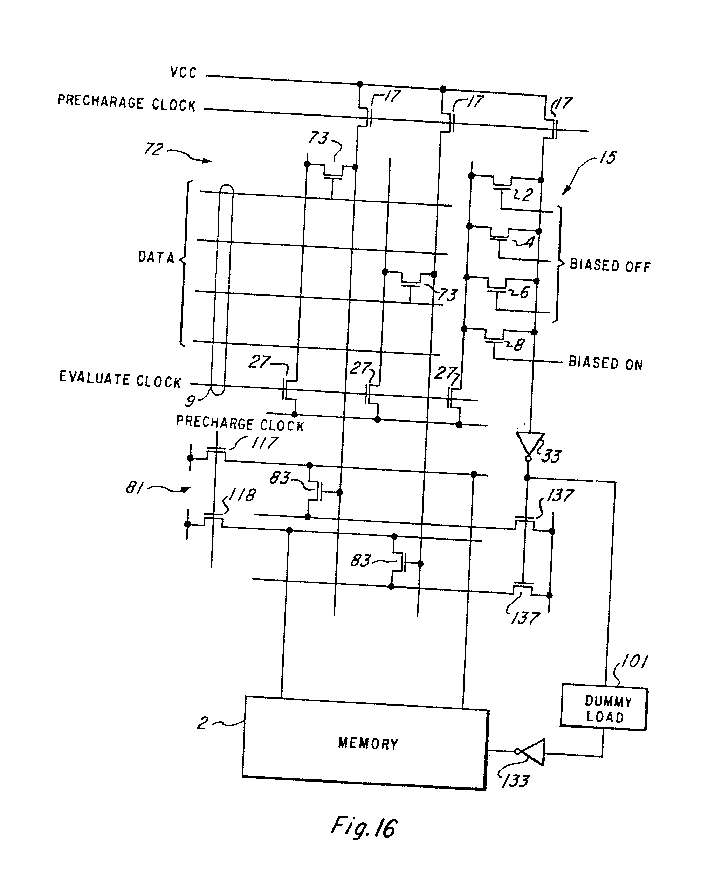

Figure 16, to which reference should now be made, there is shown a schematic diagram of a programmable logic array 100 whose outputs are connected to a memory 2. The programmable logic array 100 includes two stages a first decode stage 72 in which the data that is present on data bus 9 decodes information according to the placement of transistors 73 between the x-coordinates that is represented by the data IN lines and the y-coordinates, represented by vertical lines 75, 76, 77, and 79. When the data is decoded, it is applied to a second stage 81, which is the output stage and is used to drive the load which in the case of Figure 16, is a memory as well as other circuits that may be connected to the data bus 93. The programming of the output stage is represented by transistors 83, which provide connections the vertical lines 75, 76, 77, and the horizontal lines 85 and 87. The dummy load circuit 15 is connected in the worst case condition by having a single transistor 37 connected between the x-axis and the y-axis of the programmable logic array 100. It is obvious that the greater the number of conducting transistors, the quicker the lines that are connected to the transistors 27 will be discharged. Consequently, a single on transistor, and all off transistors for all data lines except one is the worst case arrangement. Thus a transistor 8 is biased on and transistors 2, 4 and 6 are biased off in the embodiment of Figure 16. The enable signal is ANDed with the clock signal by the configuration of the gates 37 and 27 that is contained within the dummy logic 15. This causes a pulse to be provided on the output of the inverter 33, thus enabling the transistors 137 so that the second stage 81 of the programmable logic array may be evaluated, provided that the clock signal is removed from the transistors on 17. The output is applied a data bus 83 as well as to the memory 2 where if the second dummy circuit 101 is evaluated, then the invertor 133, provides a store pulse to the memory 2, and the output of the programmable logic array may be stored in memory 2.

0174397

-22-

WHAT IS CLAIMED IS:

1.  An multi-level logic circuit comprising:

a first plurality of N logic circuit means, connected in cascade arrangement where N is a positive integer, for performaning logic operation;

a second plurality of N dummy logic circuit means, connected in cascade arrangement where M is a positive integer, for providing a plurality of M evaluation pulses;

clock circuit means for providing a precharge signal to each member of the plurality logic circuit means and the dummy logic circuit means; and

circuit means for evaluating each member of the plurality of logic circuit means with a corresponding member of the plurality of evaluation pulses.

2.  The multi-level logic circuit according to Claim 1 comprises:

a programmmable logic array.

3.  The multi-level logic circuit according to Claim 2 wherein the programmable logic array comprises:

an x by y matrix logic means where x and y are both positive integers representing the data input line and the number of decode lines respectively; and (Claim 3 continued)

the dummy logic means include a single logic array means connected in a worst case condition to provide an enable pulse to the x by y matrix logic means.

4.   The multi-level logic circuit according to Claim 3 wherein the programmable logic array further comprises:

an output stage means for providing output signals representative of the program decoded  by the signal and the data input lines the program stored in the x by y matrix, said output stage means being enabled by the enable signal.

5.   The multi-level logic circuit according to Claim 1 wherein circuit means comprises:

AND gate means for combining the precharge signal with the evaluation signal such that when the precharge signal is not present and the evaluation signal is present, a corresponding logic circuit means is evaluated.

6.   A method of implementing a multi-level logic  circuit comprising:

connecting a first plurality of logic circuit means in cascade arrangements wherein the plurality of  logic circuit means are for performing logic operations;

connecting a second plurality dummy logic circuit means in cascade arrangement wherein the dummy logic circuit means provide a plurality of  evaluation pluses from the second plurality of  dummy logic circuits;

(Claim 6 continued)    -24-

providing a precharge signal to each member of the plurality logic circuit means and the dummy logic circuit means; and

evaluating each member of the plurality logic circuit means with the corresponding member of a plurality of evaluation pulses.


7.  A programmable logic array comprising:

a x by y matrix logic means where x and y are both positive integers representing a data input line and the number of decode lines respectively; and

a dummy logic means that includes a single logic array means connected in a worse case arrangement to provide and evaluation pulse to the x and y matrix logic means.

8.  The programmable logic array according to Claim 7 further comprising an output stage means for providing an output signal representative of the program decoded by the signal on the data input links and the program stored in the x by y matrix means.

9. A digital multiplication circuit comprising:

a Booth recoder means for recoding a multiplier into N Booth operation sets where N is a positive integer that equals one half the number of bits in the multiplier;

a plurality of N partial product selector means connected in cascade arrangement of multiplicand sets of M length and each member of the plurality of N partial product selector means being connected to a member of the M operation sets for implementing the recoded Booth operation set on a multiplicand set and where M is a positive integer;

summation means for summing the contents of the plurality of N partial product selector means the summation means being located between members of the plurality of N partial product selector means; and

a domino means including summation circuit means for generating a next evaluation pulse to evaluate a corresponding member of the plurality of partial product selector means whose input circuits are connected to a corresponding summation means output.

10. The digital multiplication circuit according to Claim 9 wherein the domino circuit means comprises:

a clock means for providing a precharge signal; and

a partial product stage means connected in cascade arrangement for converting the precharge signal to an evaluative signal.

11. The digital multiplication circuit according to Claim 10 wherein the domino circuit means futher comprises:

a plurality of dummy load means; and

a plurality of summation circuits connected to a pre-selected dummy load means for providing an evaluation pulse to each member of plurality of N partial product selector means at the completion of the Booth operation set that is connected to the corresponding partial product selector means.

12. The digital multiplication circuit according to Claim 9 wherein the summation means comprises;

a plurality of full adder circuit means for combining a first input, a second input, and a third input.

13. The digital multiplication circuit according to Claim 11 wherein each of the plurality of the summation circuit means comprises:

a full adder circuit means having a first input a second input, and a third input.

14. The digital multiplication circuit according to Claim 9 wherein the summation means comprises:

a first plurality of full adder circuits connected to sum the output of a first multiplicand set from a preselected partial product selector means, a second multiplicand set from a second preselected partial product selector means and a third multiplicand set of a third preselected partial product selector means.

15. The digital multiplication circuit according to Claim 14 wherein the summation means further comprising:

a second set of full adder circuit means for combining the output of the first set of full adder means with the output of a fourth multiplicand set of a fourth preselected partial product selector means.

16. The digital multiplication circuit according to Claim 10 wherein the summation means further comprises:

a third set of full adder circuit means connected to combine the output of the second sent of full adder means with a fifth multiplicand set of a fifth preselected partial product selector means.

17. The digital multiplication circuit according to Claim 16 wherein the summation means further comprises:

a fourth set of full adder means for combining the output of this third set of the full adder means with a sixth multiplicand set of a sixth preselected partial product selector means.

18. The digital multiplication circuit according to Claim 9 further comprising;

an intermediate set of registers for storing the outputs of the plurality of the partial product selectors and the summation means.

19. The digital multiplication circuit according to Claim 18 further comprising;

a second summation circuit means for selectively combining the outputs of the intermediate register means to obtain the product of the multiplicand and the multiplier.

20. The digital multiplication circuit means according to Claim 19 further comprising:

a plurality of storage register means for storing the products of the multiplier and the multiplicand

21. A method of performing digital multiplication comprising:

decoding a multiplier into N Booth operation sets where N is a positive integer that equals one half the number of bits in the multiplier;

implementing a decoded Booth operation set on a multiplicand with a plurality of N partial product selector means connected in cascade arrangement and each member of the plurality of N partial product selector means being connected to receive a member of the N operation sets;

summing the contents of the plurality of N partial product selector means with a summation means located between members of the plurality of N partial product registers; and

generating a next evaluation pulse to evaluate the member of the plurality of partial product selector means whose input circuits are connected to a corresponding summation means output.

22. The method according to Claim 19 wherein the step of generating a next evaluation pulse comprises:

providing a precharge signal; and

converting the precharge signal to an evaluative signal.

Fig.1

100

1/17

0174397

Fig.2

0174397

Fig.3

161

Fig. 4

PRECHARGE CLOCK 329
EVALUATE CLOCK 331
STORE CLOCK 333

PRECHARGE CSA AND PP 337
EVALUATE ALL PP
SET UP INPUTS 339
EVALUATE IST CSA 351
338
EVALUATE 2ND CSA 353
EVALUATE 3RD CSA 355
347 357
345 349 359
EVALUATE 4TH CSA
STORE INTERMEDIATE RESULTS
361

PHASE 1 365

PRECHARGE CRA 341
ACCUMULATE PREVIOUS INTERMEDIATE RESULT 343
STORE FINAL RESULT
363
365

PHASE 2 367

321 323 335 100ns 325 326 327

4 / 17

0174397

Fig. 5 A(1)

FROM FIG. 5A(1)

187 — 4TH CSA DELAY — Q_D

307 — CONTROL LOGIC

213 →

309 — 310 — 3RD CARRY SAVE ADDED PARTIAL PRODUCT SELECTER

185 — 3RD CSA DELAY — Q_p

311 — 209 — 201

185 —

311 — 310 — 2ND CARRY SAVE ADDER PARTIAL PRODUCT SELECTER

183 — 2ND CSA DELAY — Q_p

201 — 199

TO FIG. 5B(2)

TO FIG. 5A(3)

Fig.5A(2)

Fig. 5A(3)

FROM FIG. 5A(2)

313

199

FROM FIG. 5A(2)

310 — 1ST CARRY SAVE ADDER PARTIAL PRODUCT SELECTER

181 — 1ST CSA DELAY — Qp

179 — PPR DELAY — Qp

197

195

191

372

193

191

370

TO FIG. 5B(3)

7/17

0174397

Fig. 5B(1)

FROM FIG. 5A(1)

TO FIG. 5B(2)

0174397

Fig.5B(2)

0174397

Fig.5B(3)

FROM FIG. 5B(2)

BOOTH RECODER

BOOTH RECODER

FROM FIG. 5A(3)

Fig.6

Fig.7

189

191

Fig.8

179

0174397

Fig. 9

Fig. 10

Fig. 11

0174397

Fig.12A

CONTROL A

N SCAN COMMAND

471

CONTROL A

481

Fig.12B

Fig.13

Fig. 14

Fig.15

Fig.16